Europäisches Patentamt

European Patent Office

Office européen des brevets

(11) Publication number: **0 665 657 A2**

# EUROPEAN PATENT APPLICATION

(21) Application number: **94120391.1**

(22) Date of filing: **22.12.94**

(51) Int. Cl.6: **H04B 7/005**, H03G 3/20

(30) Priority: **29.01.94 GB 9401703**

(43) Date of publication of application:
**02.08.95 Bulletin 95/31**

(84) Designated Contracting States:
**DE FR IT NL**

(71) Applicant: **MOTOROLA LTD**
**Jays Close,**
**Viables Industrial Estate**
**Basingstoke,**
**Hampshire RG22 4PD (GB)**

(72) Inventor: **Wray, Anthony John**
**33 Scarlatti Road,**
**Hatch Warren**
**Basingstoke,**
**Hampshire RG22 4LY (GB)**

Inventor: **Bastani, Babak**
**40 Sutton Hall Road**
**Heston,**
**London TW5 0PY (GB)**
Inventor: **Boscovic, Dragan**
**48 Meadowland,**
**Chineham**
**Basingstoke,**
**Hampshire RG24 0XL (GB)**

(74) Representative: **Dunlop, Hugh Christopher et al**
**Motorola,**
**European Intellectual Property,**
**Midpoint,**
**Alencon Link**
**Basingstoke,**
**Hampshire RG21 1PL (GB)**

(54) **Power amplifier for radio transmitter and dual mode remote radio.**

(57) A power amplifier for a radio transmitter is described. For operation at optimum efficiency, the amplifier has a bias level control input (52) for control of direct current power consumption by the amplifier (50). A sample-and-hold arrangement (80) sampling signals output from the amplifier over a first period of time. Computations are performed (13, 86) on the signals sampled; and the bias level input of the amplifier is adjusted at a time following the first period of time. The arrangement is particulary suitable for use in a radio system comprising a remote radio (10) and a base station (20) where the radio is arranged to operate in a first mode under the control of the base station (e.g. trunked mode) and a second, direct radio-to-radio, mode of operation.

FIG.2

Field of the Invention

This invention relates to a power amplifier for a radio transmitter. Additionally and separately, it relates to a remote radio suitable for use in a radio system comprising a remote radio and a base station. It particularly relates to such a radio arranged to operate in first and second modes, where, in the first mode, it is controlled to receive channel control commands from a base station and in the second mode it is arranged for direct communication with another remote radio.

Background to the Invention

Continuing pressure on the limited spectrum available for communication systems is forcing the development of spectrally-efficient linear modulation schemes. Since the envelopes of these linear modulation schemes fluctuate, intermodulation products can be generated in the non-linear power amplifier. Specifically in the private mobile radio (PMR) environment, restrictions on out-of-band emissions are severe (to the order of -60 to -70 dBc) and therefore linear modulation schemes require highly linear transmitters.

The emphasis in portable PMR equipment is also to increase battery life. Hence, the operating efficiencies of the amplifiers used must be maximised. To achieve both linearity and efficiency, so called linearisation techniques are employed by improving the linearity of the more efficient amplifier classes e.g. class AB, B or C amplifiers. One such linearising technique often used in designing linear transmitters at present is Cartesian Feedback. This is a "closed loop" negative feedback technique which `sums' the baseband feedback signal in it's digital "I" and "Q" formats with the "I" and "Q" input signals prior to amplifying and up-converting this signal to it's required output frequency and power level.

Cartesian feedback linearisation is one technique that has been proposed for implementing a TETRA (Trans European digital trunked radio). To linearise the transmitter prior to transmitting data or voice, phase and amplitude training of the transmitter is required to achieve linearity and stability. This is accommodated within a Common Linearisation Channel (CLCH) as is described in UK Patent Application No. 9222922.8 filed on 2 November 1992 (International Patent Application No. PCT/EP93/07243). The CLCH frame occurs both in the traffic channels and in the control channel to allow a radio to train prior to gaining access to the system.

It would be desirable to use a TETRA radios in a "conventional", i.e. direct radio-to-radio mode of operation. A very useful and desirable implementation for TETRA manufacturers would be for one radio unit to have the ability to operate in both trunked and direct modes. Within the TETRA standard, there is a requirement for a "Dual Watch" facility, which requires some monitoring of a control channel during transmissions. This effectively limits the direct mode operation to a time-division-multiplex (TDM) form, as continuous transmissions would preclude the ability to monitor signals on the control channel.

Problems associated with attempting to operate a linearised amplifier in direct mode operation are that the closed loop technique has a significant wide band noise problem and there is no means to allocate time in which to linearise (train) the transmitter to maintain stability and the required linearity, without the possible transient splattering problems associated with training. On the other hand, if a linearised amplifier is not used, there is currently no means of adequately controlling linearity and efficiency.

In the context of power control in a time-slot divided radio transmitter, European Patent Application EP-A-0369135 of Motorola Inc. describes the measuring of output power at one point in time and the adjustment of output power at a later point.

Summary of the Invention

According to a first aspect of the invention, a power amplifier for a radio transmitter is provided, the amplifier comprising: an input, an output and a bias level control input for control of direct current power consumption by the amplifier; sampling means coupled to the output for sampling signals output from the amplifier over a first period of time; computation means for performing computations on the signals sampled; and control means coupled to the computation means and to the bias level input for adjusting the bias level input at a time following the first period of time, thereby to improve the efficiency of the amplifier.

In effect, a quasi-closed loop arrangement is provided, i.e. an alternative method of "training" the transmitter is provided that avoids transient interference. It will be shown that there is enough time to perform this new form of "training" given the requirements of operating the dual watch function.

In accordance with a second aspect of the invention, a remote radio for a radio system is provided comprising a remote radio and a base station. The remote radio comprises transmitting means, receiving means and control means coupled to the transmitting means and the receiving means for control thereof, the control means being arranged to control the radio in first and second modes, where, in the first mode, the receiving means is controlled to receive channel control commands from a base station and in the second mode the transmitting means and receiving means are controlled for direct communication with another remote radio. The transmitting means comprises: a power amplifier, measuring means for measuring the output from the power amplifier, first and second feedback means for controlling the power amplifier in response to the measuring means, and switching means for selectively switching between the first and second feedback means. The first feedback means is arranged for closed-loop adjustment of the power amplifier, the second feedback means is arranged for open-loop adjustment of the power amplifier and comprises sample-and-hold means for measuring the output of the amplifier in a first time frame and adjusting it in a second time frame and the switching means is controlled by the control means to select the first feedback means for operation in the first mode and the second feedback means for operation in the second mode.

Gain adjustment means are preferably provided for changing a gain parameter of the power amplifier in response to the switching means.

The receiving means are preferably arranged to receive, in the first mode of operation, a training sequence from the base station and to adjust a parameter of the power amplifier and first feedback means in response to the training sequence.

The second feedback means may comprise computation means for performing computations on the output of the amplifier during a time period between the first time frame and the second time frame. The control means may be arranged to control the transmitting means and the receiving means to alternatively transmit and receive and the computation means may be arranged to perform the computations in a time during switching between transmit and receive.

In a preferred embodiment, the second feedback means comprise transform computation means for calculating at least one of on-channel, adjacent channel and total power, for the output of the amplifier. Further preferred features are: that the power amplifier has an adjustable drive level parameter and the control means is arranged to change the drive level parameter in response to the computation means; the control means is arranged to increase the drive level parameter when on channel power is below a threshold; the control means is arranged to increase the drive level parameter when adjacent channel power is below a threshold; the power amplifier has an adjustable direct current consumption parameter and the control means is arranged to change the direct current consumption parameter in response to the computation means and the control means is arranged to increase the direct current consumption parameter when adjacent channel power is not below a threshold.

The invention has the advantages of open loop during direct mode operation, which are: (i) a reduction in the wide band noise level (as confirmed by measurements below) and (ii) no transient splattering during training.

The arrangement is suitable for different forms of power control.

A preferred embodiment of the invention is now described, by way of example only, with reference to the drawings. The preferred embodiment of the invention is described using a Cartesian feedback transmitter but the invention is equally applicable to alternative linearising methods using such a feedback approach e.g. Adaptive Predistortion Linearisation.

## Brief description of the Drawings

Fig. 1 shows an overall diagram of a radio system comprising a base station and a remote radio operating in a first mode and two remote radios operating in a second mode.

Fig. 2 is a block diagram of the remote radio of Fig. 1 in its preferred embodiment.

Fig 3 shows a flow diagram of steps of operation of control elements of the circuit of Fig. 2.

Fig. 4 shows a voltage current characteristics of a typical amplifier.

Fig. 5 shows base band gain stages for elements of Fig. 2 and

Fig. 6 shows a plot of output power versus efficiency for a linearised class A B amplifier in a TDM mode.

## Detailed Description of the Preferred Embodiment

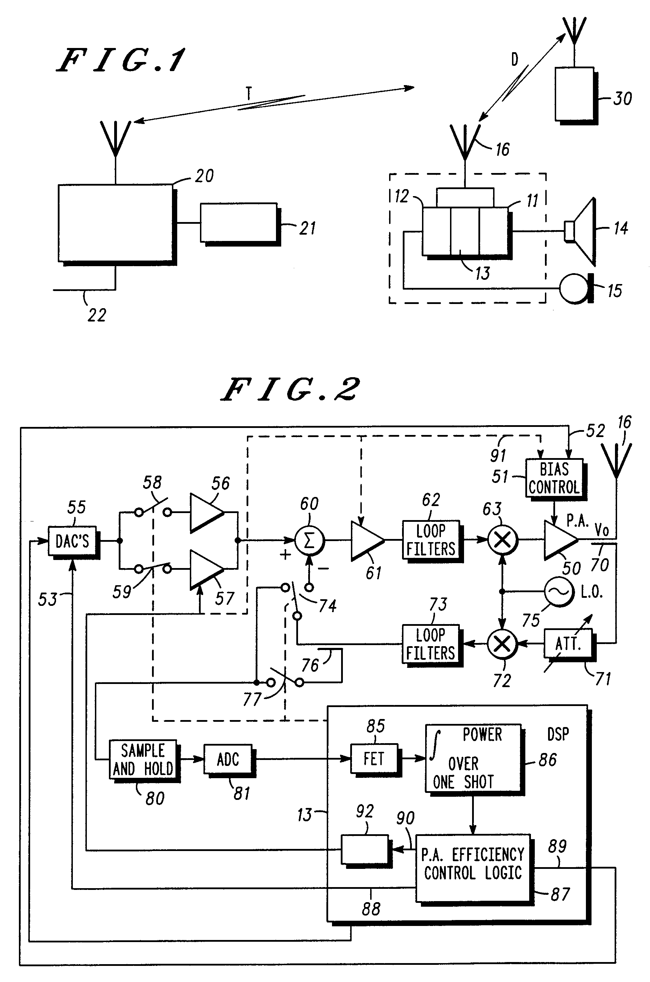

Referring to Fig. 1, a mobile radio 10 is shown comprising a receiver part 11, a transmitter part 12, a processor 13 which may be a digital signal processor (DSP) or a microprocessor or both but will hereafter be described as a DSP. The radio has an output connected to the receiver part in the form of a loud speaker 14 and an input connected to the transmitter part in the form of a microphone 15. The receiver parts 11 and 12 are connected to an antenna 16.

The mobile radio 10 communicates with a base station 20, which has a trunking controller 21 connected thereto. The base station 20 can relay communications from the mobile radio 10 to another mobile radio (not shown), or can communicate via a land line connection 22 to a dispatch controller or another base station of another coverage area.

Also shown in Fig. 1 is a second mobile radio 30. Mobile radio 10 is capable of communicating with mobile radio 20 in a trunking mode, under the control of trunking controller 21 (as represented by arrow T) and alternatively, is capable of communicating with mobile radio 30 in a direct mode (as represented by arrow D). Mobile radio 30 may be identical to mobile radio 10, in which case it too is capable of trunking communication with base station 20 under the control of trunking controller 21.

Communication between the mobile radio 10 and the base station 20 is controlled as described in UK patent application no. 9222922.8 (international patent application PCT/EP 93/07243) filed on 2 November 1992.

Referring now to Fig. 2, details of the transmitter part 12 of the mobile radio 10 are shown. The transmitter part 12 comprises a power amplifier (P.A.) 50, which has bias control circuitry 51 receiving bias level input 52. Bias control circuit 51 comprises, for example, a digital-analog converter, the analog output of which is coupled to a transistor element which provides adjustable bias resistance for the power amplifier 50.The power amplifier 50 receives an input from the DSP 13 via digital-analog converter (DAC) 55, one of two baseband gain elements 56 and 57, selectable by switches 58 and 59, and then via summing element 60, loop gain element 61, loop filters 62 and mixer 63. The DAC 55 has a linearity control input 53 for controlling the number of bits used in its digital-to-analog conversion. The output of power amplifier 50 is sampled by coupler 70 and the sampled output is attenuated in variable attenuator 71, down converted in mixer 72, filtered in filters 73 and fed to summing element 60 for subtraction from the incoming signal (Vi). Baseband gain element 56 has gain = G(1 + AB), where A is the forward loop gain through element 61 and B is the feedback gain though attenuator 71. base band element 57 is adjustable to give gain = G.

Between loop filters 73 and summing elements 60 is a two-way switching element 74. Additionally, an optional coupling element 76 is shown and a switch 77.

Connected to the alternative pole of switching element 74 is a sample and hold circuit element 80 coupled to an analog-digital converter (ADC) 81 providing a digital input to the DSP 13. The DSP 13 has the following elements in software. It has a fast Fourier transform inverter routine 85 coupled to a power integrator 86, coupled in turn to power amplifier efficiency control logic 87. A first output 88 of logic 87 is passed to control input 53 of digital-analog converter 55. A second output 89 is fed to the bias control circuit 51 at the top of the figure. A third output 90 is passed to power control logic 92 which is connected to a control input of baseband gain element 57 and (optionally) a control input of gain element 61 and a power control input 91 of bias control circuit 51.

The operation of the circuit of Fig. 2 is as follows.

When operating in a trunking mode, and following phase training, switch 58 is closed, switch 59 is opened and switching element 74 is in its right-hand position. The power amplifier is linearised by inputting of a training sequence from the DSP 13. This training sequence is a base band signal which is amplified by gain elements 56 and 61 and mixed to the transmission frequency in mixer 63, receiving a carrier input from local oscillator 75. Bias control 51 provides no control signal or provides a datum level of control signal and the training sequence is transmitted during an assigned time slot and sampled by coupler 70. The sample signal is attenuated in attenuator 71, mixed to base band in mixer 72, filtered in filter 73 and subtracted from the incoming signal in summing element 60. The degree of attenuation in attenuator 71 is controlled to maintain the power of amplifier 60 below its clip level. Thereafter, signals can be transmitted at times assigned to the mobile radio 10 by the trunking controller 21.

When it is desired to operate the mobile radio 10 in direct mode, eg. by inputting a command or pressing a button on the mobile radio 10, switch 58 is opened, switch 59 is closed, and (in this embodiment) switching element 74 is switched to its left-hand position. In this mode the operation is as follows.

A signal for transmission is input by the DSP 13 to the DAC 55, amplified in gain elements 57 and 61 and transmitted by power amplifier 50. Transmission continues for an assigned TDM time slot and at frequent intervals during the time slot, the output from the power amplifier is sampled in sample and hold circuitry 80 and the sampled output is fed to FFT routine 85. After Fourier transformation of the samples, the power is integrated in integrator routine 86 over an entire time slot. Sample and hold circuitry 80 samples the power within an assigned channel (on-channel power) as well as the power in an adjacent channel (adjacent channel power). Total power is also sampled.

The results of integration of the power values over a slot are compared with thresholds in control logic 87 (as described below) and, depending upon the decisions made, signals are provided to DACs 53, bias control circuit 51 and baseband gain element 57. These signals are used to control the power amplifier 50 in the next slot, that is to say on the next occurrence of opening of the power amplifier 50.

The sample and hold data from circuitry 80 is buffered in memory in the DSP 13 and processed during a synthesiser switching period, that is to say a period during which the mobile radio 10 switches between operation of its transmitter part 12 and its receiver part 11, thereby avoiding adding to the processing required by the DSP during transmit slots. Switching between transmit and receive occurs in a radio performing a dual watch function. If no dual watch function is performed, the time selected for performing the processing will depend on other factors. The processing in question can be achieved within either of the transmit-receive or receive-transmit switching periods, each being 4 msecs. in duration.

The CLCH structure, although available in the trunked case, is not available in the direct mode case. Hence, to operate a quasi-closed loop feedback approach for direct mode operation the transmitter needs to perform both it's lineariser training, switching to and from the control channel and monitoring of the control channel in spare time in the frame. Current synthesiser switching technology can achieve "lock" in approx. 4 msecs. The processing time required to perform a 1024 point FFT in a standard 27 MHz DSP is around 1.5 msecs, including the time required to bring in the sampled data from an external ADC.

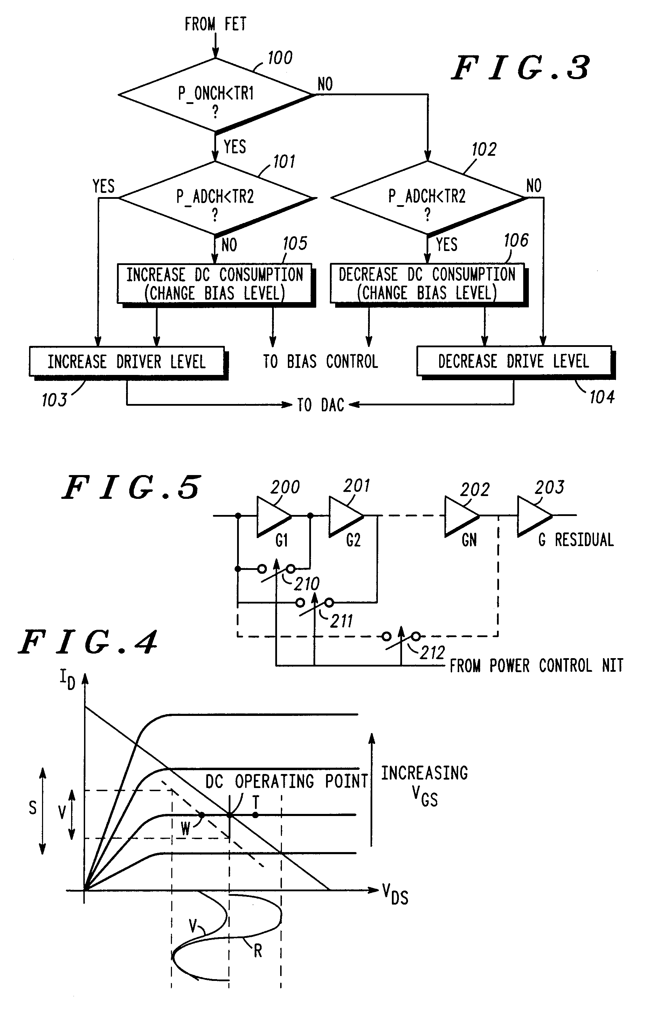

Once the FFT is performed on the signal, the on-channel adjacent-channel and total power are calculated for every transmit slot. The procedure detailing the monitoring and control of the transmitter performance is shown in the flow diagram in Fig. 3.

In the process of Fig. 3, step 100 compares on-channel power with a first threshold Tr1 which is a threshold related to nominal RF power. If on-channel power is less than this threshold, the process passes to step 101, otherwise it passes to step 102. Steps 101 and 102 are identical. Each compares adjacent channel power with a second threshold Tr2, calculated as follows;

Tr2 = ACCP x Total Power + Margin, where

ACCP = Adjacent Channel Coupled Power (which is an adjacent-channel:total power ratio measurement).

If this threshold is not exceeded, step 101 proceeds to step 103 or step 102 proceeds to step 106. If adjacent channel power is not less than Tr2, step 101 proceeds to step 105 or step 102 proceeds to step 106. In step 105 the DC consumption level is increased by changing the bias level of signal 52. Upon changing the bias level, the power level can be adjusted on control line 90 for optimum efficiency at the new bias level. Note that in addition or as an alternative to adjusting baseband gain, gain in the power amplifier 50 can be adjusted as represented by dotted arrow 91 in Fig. 2. In step 106 the DC consumption level is decreased. Steps 105 and 106 proceed to steps 103 and 104 respectively. In these steps, the drive level is increased and decreased respectively in signal 53.

As a result of the process of Fig. 3, the on-channel power measurement is related to the RF output power whilst adjacent-channel:total power ratio measurement (Adjacent Channel Coupled Power) is used as a measure of P.A. linearity. Each of the measured values is compared to the corresponding threshold levels and the maximum P.A. efficiency is achieved by adjusting the drive levels from the DSP and setting the P.A. DC consumption optimally by changing either the bias current or voltage.

In a preferred option, when on-channel power is approximately equal to Tr5 in step 100, the process passes to step 102. This has the advantage of reducing the DC consumption level and increasing efficiency at the margin.

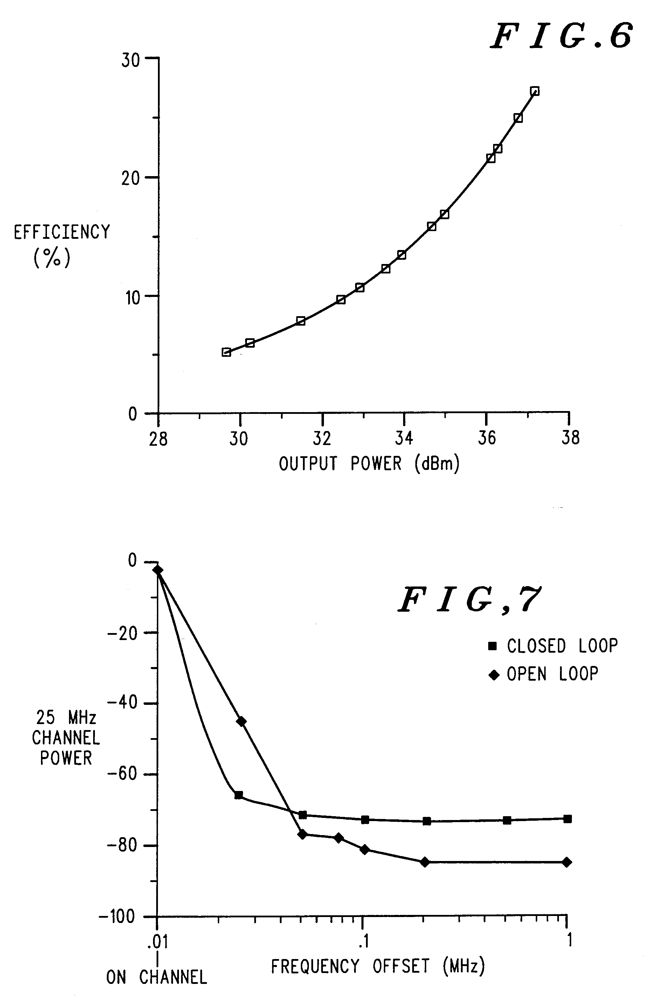

By changing the DC operating point, the linearity and the efficiency of the P.A. can be adjusted and optimised. This is illustrated in Fig. 4.

Fig. 4 shows a sketch graph for a field-effect transistor amplifier of drain-source $V_{DS}$ versus drain current $I_D$ at different gate voltages $V_{GS}$. A first signal R is shown as an input signal, which will give rise to a drain current in the range S when operating about the operating point T. If a lower input signal U is present, operating about the same operating point T would give rise to the drain current in the range V. Advantageously, however, the operating point can be moved to the left, to point W (whereupon the dotted operating line is used) and the same output is achieved (V) but this time at a lower average $V_{DS}$. In conclusion, the direct current level (DC consumption) has been reduced. With lower consumption of DC power, the effieiency is increased.

A small measurement margin is included in order not to push the radio's performance too close to any given limit (not shown).

It is to be noted that the drive level can be controlled by DSP output or by baseband gain stages. The latter is illustrated in Fig.5.

Fig. 5 shows details of gain element 56 or 57 of Fig. 2. As shown, it comprises a number of gain elements 200, 201, 202 and 203 (and other elements as necessary). These have respective gains $G_1$, $G_2$, $G_N$, $G_{residual}$. Each has a by-pass switch element 210, 211, 212 et., where the switching of each by-pass switch element is controlled by power control logic in the DSP 13. This power control logic is not illustrated in detail but it is used for course base band gain control. Fine adjustment of the drive level of the power amplifier is achieved by the control of the DSP output level.

Implementing power control in this manner preserves the power amplifier efficiency for all RF transmitting levels, which is of critical importance in hand-portable radio units. The circuit illustrated achieves a wide dynamic range for the drive level changes required.

Instead of switching element 74 to its left hand position and operating in open loop mode, switch 74 can be held in its right-hand position for direct-mode operation and switch 77 can be closed and coupler 76 used to sample the signals from loop filters 73 while continuing closed loop operation.

In this case the efficiency of the amplifier is enhanced by periodically sampling the feedback signals, performing power calculations over a predetermined period of time and adjusting the bias of the amplifier 50 using bias control 51 following completion of those calculations. The power may be sampled and integrated over the period of a single time slot, in the case of TDM operation or over any suitable period of time in continuous or FDMA (frequency-division multiple-access) operation.

In direct mode, a transmitter operates at a near-continuous rate with the consequence that the characteristics of the transmitter change by a much greater level during transmissions than in any non-continuous case. Then either:- (i) the transmitter exhibits adjacent channel interference due to an increase in gain and over-driving of some of the amplification stages, thereby reducing the transmitter's IMR (inter-modulation range) performance or (ii) the transmitter is backed off sufficiently to avoid the possibility of over-driving occurring - this then causes the radio to operate at a significantly reduced efficiency rating.

Measurements have shown that a 3 dB back-off from the optimum P.A. drive level typically reduces the efficiency of the P.A., in the closed loop Cartesian feedback case, from 27 % down to 17 % - a critical reduction when considering a portable TETRA product (see Fig. 6).

The arrangement described herein allows minimum backing-off of the power amplifier in spite of near-continuous operation.

Another critical system performance for direct mode operation is usable coverage range. As mentioned, wide band noise severely impacts this range. Fig. 7 shows the output power level against frequencey offset from the center of a 25kH channel. As shown, wide band noise is far greater in the closed loop case than in the open loop case by more than 10 dB. Reducing the loop gain and consequently the transmitter's linearity, by either increasing the feedback attenuation or decreasing the forward path gain, has little effect on the wide band noise level (not shown).

Using the open loop arrangement described in direct mode has the advantages of:

(1) significant reduction in wide band noise (> 10 dB);
(2) significant gains in transmitter efficiency whilst preserving linearity (real time);
(3) no splattering behaviour from any closed-loop training algorithm;
(4) the training algorithm does not require a dedicated time slot;
(5) minimal extra circuitry is required.

The conducted measurements show that there is no reduction in wide band noise by relaxing the linearity requirement.

As the radio's environment changes, the transmitter's characteristics will change and some form of transmitter monitoring is very desirable. The arrangement described has the advantage of adjusting for such changes.

## Claims

1.  A power amplifier for a radio transmitter, the amplifier comprising:

    an input, an output and a bias level control input (52) for control of direct current power consumption by the amplifier (50);

    sampling means (80) coupled to the output for sampling signals output from the amplifier over a first period of time;

    computation means (13, 86) for performing computations on the signals sampled; and

    control means (13, 87) coupled to the computation means and to the bias level input for adjusting the bias level input at a time following the first period of time, thereby to improve the efficiency of the amplifier.

2.  A power amplifier according to claim 1, further comprising power adjustment means (92) coupled to said control means for adjusting output power of the amplifier in response to adjustment of said bias level by said control means.

3.  A power amplifier according to claim 1, comprising a feedback loop (70, 71, 72, 73, 60) for providing negative feedback from the output to the input of the amplifier and

    switching means (74) for selectively opening and closing the loop, wherein

    the control means (13) are coupled to the switching means to perform adjusting of the bias level in response to said computation means when the loop is open.

4.  A remote radio for a radio system comprising a remote radio (10) and a base station (20) , the remote radio comprising transmitting means (12), receiving means (11) and control means (13) coupled to the transmitting means and the receiving means for control thereof, the control means being arranged to control the radio in first and second modes, where, in the first mode, the receiving means is controlled to receive channel control commands from a base station and in the second mode the transmitting means and receiving means are controlled for direct communication with another remote radio (30),

the transmitting means comprising:

a power amplifier (50), measuring means (70) for measuring the output from the power amplifier, first (60) and second (80, 81, 85, 86, 87, 89, 52, 51) feedback means for controlling the power amplifier in response to the measuring means, and switching means (74) for selectively switching between the first and second feedback means, wherein

the first feedback means (60) is arranged for closed-loop adjustment of the power amplifier,

the second feedback means is arranged for open-loop adjustment of the power amplifier and comprises sample-and-hold means (80) for measuring the output of the amplifier in a first time frame and adjusting it in a second time frame and

the switching means (74) is controlled by the control means (13) to select the first feedback means for operation in the first mode and the second feedback means for operation in the second mode.

5. A radio according to claim 4, further comprising gain adjustment means (56, 57, 58, 59) for changing a gain parameter of the power amplifier in response to the switching means.

6. A radio according to claim 4 or 5, wherein the receiving means (11) are arranged to receive, in the first mode of operation, a training sequence from the base station and to adjust a parameter of the power amplifier and first feedback means in response to the training sequence.

7. A radio according to claim 4, wherein the second feedback means (80, 81, 85, 86, 87, 89, 52, 51) comprise computation means (86) for performing computations on the output of the amplifier during a time period between the first time frame and the second time frame.

8. A radio according to claim 7, wherein the control means (13) are arranged to control the transmitting means and the receiving means to alternatively transmit and receive and wherein the computation means is arranged to perform the computations in a time during switching between transmit and receive.

9. A radio according to any one of claims 4 to 8, wherein the second feedback means (80, 81, 85, 86, 87, 89, 52, 51) comprise transform computation means (85) for calculating at least one of on-channel, adjacent channel and total power, for the output of the amplifier.

10. A radio according to claim 9, wherein the power amplifier has an adjustable drive level parameter and the control means is arranged to change the drive level parameter in response to the computation means.

11. A radio according to claim 10, wherein the control means is arranged (101, 102) to increase the drive level parameter when adjacent channel power is below a threshold.

12. A radio according to claim 9, wherein the power amplifier (50) has an adjustable direct current consumption parameter and the control means is arranged (105, 106) to change the direct current consumption parameter in response to the computation means.

13. A radio according to claim 12, wherein the control means is arranged (105) to increase the direct current consumption parameter when adjacent channel power is not below a threshold.

# FIG.1

# FIG.2

FIG.3

FIG.5

FIG.4

*FIG.6*

EFFICIENCY
(%)

OUTPUT POWER (dBm)

*FIG,7*

■ CLOSED LOOP
◆ OPEN LOOP

25 MHz
CHANNEL
POWER

ON CHANNEL

FREQUENCY OFFSET (MHz)